(19)

**Europäisches Patentamt**

**European Patent Office**

**Office européen des brevets**

(11) **EP 4 517 915 B1**

(12) **EUROPEAN PATENT SPECIFICATION**

(45) Date of publication and mention
of the grant of the patent:
**11.03.2026 Bulletin 2026/11**

(21) Application number: **23194351.5**

(22) Date of filing: **30.08.2023**

(51) International Patent Classification (IPC):
*G01N 29/14* (2006.01)    *H01M 10/42* (2006.01)
*G01N 29/44* (2006.01)    *G01N 29/42* (2006.01)

(52) Cooperative Patent Classification (CPC):
**H01M 10/4285; G01N 29/14; G01N 29/42;**
**G01N 29/4481;** H01M 2220/20; Y02E 60/10

(54) **PASSIVE DETECTION OF THERMAL RUNAWAY USING ACOUSTIC WAVES**

PASSIVE DETEKTION VON THERMISCHEM DURCHGEHEN MIT AKUSTISCHEN WELLEN

DÉTECTION PASSIVE D'EMBALLEMENT THERMIQUE À L'AIDE D'ONDES ACOUSTIQUES

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(43) Date of publication of application:
**05.03.2025 Bulletin 2025/10**

(73) Proprietor: **VOLVO TRUCK CORPORATION**
**405 08 Göteborg (SE)**

(72) Inventors:
• **MOVAGHAR, Amirreza**
  **412 73 GÖTEBORG (SE)**
• **ANTHAM, Rajukiran**
  **417 25 GÖTEBORG (SE)**
• **TAMADONDAR, Masood**
  **431 30 MÖLNDAL (SE)**
• **JOHANSSON,, Patrik**
  **414 56 GÖTEBORG (SE)**

(74) Representative: **Kransell & Wennborg KB**
**P.O. Box 2096**
**403 12 Göteborg (SE)**

(56) References cited:
**EP-A1- 3 772 428**      **CN-U- 218 824 631**
**US-A1- 2022 123 559**   **US-A1- 2022 340 042**

## Description

## TECHNICAL FIELD

The disclosure relates generally to safety in electrical energy storage systems. In particular aspects, the disclosure relates to passive detection of thermal runaway using acoustic waves. The disclosure can be applied to heavy-duty vehicles, such as trucks, buses, and construction equipment, among other vehicle types. Furthermore, the disclosure can equally well be applied to stationary applications and marine applications. Although the disclosure may be described with respect to a particular vehicle, the disclosure is not restricted to any particular vehicle.

## BACKGROUND

Thermal runaway events in electrical energy storage systems of vehicles are hazardous for occupants of the vehicle and to surrounding people. Furthermore, thermal runaway events may cause damage to the vehicle and potentially also to objects near the vehicle.

Current safety features implemented on electrical energy storage systems are typically heavily dependent on temperature sensors or thermocouples arranged on the internal structures or on the cells of the electrical energy storage systems. However, for an effective warning system, the warning should come sufficiently early so that preventive measures or safety measures can be applied well before the thermal runaway event actually occurs and excessive heat is developed. Prior art documents EP 3 772 428, CN 218 824 631 and US 2022/123559 disclose various systems and methods for acoustic detection of thermal runaway.

## SUMMARY

According to a first aspect of the disclosure, there is provided a computer system comprising processing circuitry configured to: receive sensing data from at least one sensor arranged to detect sound waves emitted from electrical energy storage cells of an electrical energy storage system, the sensing data indicating at least one characteristic of the sound waves, apply an algorithm configured to predict a thermal runaway event by analyzing the sensing data, provide a message if the outcome of the analysis is that a thermal runaway is predicted.

The first aspect of the disclosure may seek to improve the detection of thermal runaway events in an electrical energy storage system. A technical benefit may include earlier detection which allows more time and opportunity to take measures in response to the predicted thermal runaway event.

Optionally in some examples, including in at least one preferred example, the algorithm may be a machine learning model trained to predict thermal runaway events from detection of acoustic waves generated from gas bubbles in electrical energy storage cells. A technical benefit may include improved ability to detect thermal runaway events earlier and with improved accuracy.

Optionally in some examples, including in at least one preferred example, the machine learning model may be a supervised learning model trained on acoustic data from test cells to create a fingerprint library of characteristic sounds of thermal runaway events. A technical benefit may include an improved model for predicting the thermal runaway event.

The processing circuitry is further configured to: predict the thermal runaway event by analyzing sound waves at characteristic frequencies of electrolyte boiling preceding a thermal runaway event. "Preceding" a thermal runaway is meant near or just before as in several minutes, e.g., 10-15 minutes before a thermal runaway event.

For example, the processing circuitry may be configured to analyze sound waves at frequencies below 5 kHz, such as in the range of 1-2 kHz, or below 500 Hz. A technical benefit may include the ability to detect sound waves specifically generated from gas bubbles in the electrical energy storage cells. Thus, the algorithm may filter out frequencies that are not relevant for detecting thermal runaway events through analysis of acoustic dynamics of gas bubbles. The source of the sound waves is one or more of bubble formation, bubble movement, and bubble collapse and resonance thereof.

Optionally in some examples, including in at least one preferred example, the processing circuitry may be configured to receive the sensing data wirelessly from a transmitter connected to the sensors. A technical benefit may include less complicated integration since the use of hardwires is reduced or eliminated.

Optionally in some examples, including in at least one preferred example, sensing data may be received from multiple sensors. A technical benefit may include improved detection since multiple sensors are used that can detected sound waves from more than one location of the electrical energy storage system.

Optionally in some examples, including in at least one preferred example, the sensors in the electrical energy storage system may be at least one of microphones, horn filters connected to waveguides, or accelerometers.

According to a second aspect of the disclosure, there is provided a computer-implemented method, comprising: receiving, by processing circuitry of a computer system, sensing data from at least one sensor arranged to detect sound waves emitted from electrical energy storage cells of an electrical energy storage system, the sensing data indicating at least one characteristic of the sound waves, applying, by the processing circuitry, an algorithm configured to predict a thermal runaway event by analyzing the sensing data, providing, by the processing circuitry, a message if the outcome of the analysis is that a thermal runaway is predicted.

The second aspect of the disclosure may seek to improve the detection of thermal runaway events in an electrical energy storage system. A technical benefit may include earlier detection which gives more time and opportunity to take measures in response to the predicted thermal runaway event.

Optionally in some examples, including in at least one preferred example, the algorithm is a machine learning model trained to predict thermal runaway events from detection of acoustic waves generated from gas bubbles in electrical energy storage cells. A technical benefit may include improved ability to detect thermal runaway events earlier and with improved accuracy.

Optionally in some examples, including at least one preferred example, the machine learning model is a supervised learning model trained on acoustic data from test cells to create a fingerprint library of characteristic sounds of thermal runaway events. A technical benefit may include an improved model for predicting the thermal runaway event.

The method comprises: analyzing, by the processing circuitry, sound waves at characteristic frequencies of electrolyte boiling preceding a thermal runaway event. For example, the processing circuitry may be configured to analyze sound waves at frequencies below 5 kHz, such as in the range of 1-2 kHz, or below 500 Hz, to predict the thermal runaway event. A technical benefit may include the ability to detect sound waves specifically generated from gas bubbles in the electrical energy storage cells. Thus, the algorithm may target frequencies that are most relevant for predicting thermal runaway events through detection of gas bubbles.

Optionally in some examples, including in at least one preferred example, the method may comprise: receiving, by the processing circuitry, the sensing data wirelessly from a transmitter connected to the sensors. A technical benefit may include less complicated integration since the use of hardwires is reduced or eliminated.

Optionally in some examples, including in at least one preferred example, sensing data may be received from multiple sensors configured to transmit the sensing data to the processing circuitry. The sensors each detects sound waves and transforms them to electric signals. The sensors may be configured to detect infrasound.

Optionally in some examples, including in at least one preferred example, the sensors may be at least one of microphones, horn filters connected to waveguides, or accelerometers. Accelerometers provide a relatively cost-efficient sensor solution.

There is further provided a computer program product comprising program code for performing, when executed by the processing circuitry, the method of the second aspect.

There is further provided a non-transitory computer-readable storage medium comprising instructions, which when executed by the processing circuitry, cause the processing circuitry to perform the method of the second aspect.

According to a third aspect of the disclosure, there is provided a system for detecting a thermal runaway in an electrical energy storage system of a vehicle, the system comprising: a set of sensors arranged to detect sound waves emitted from electrical energy storage cells of the electrical energy storage system, the sensing data indicating at least one characteristic of the sound waves, data collector configured to receive sensing signals from the sensors and transmit sensing data to processing circuitry configured to apply an algorithm configured to predict a thermal runaway event by analyzing the sensing data, and a vehicle processing circuitry configured to provide a message if the outcome of the analysis is that a thermal runaway is predicted.

The third aspect of the disclosure may seek to improve the detection of thermal runaway events in an electrical energy storage system. A technical benefit may include earlier detection which gives more time and opportunity to take measures in response to the predicted thermal runaway event.

Optionally in some examples, including in at least one preferred example, the system may comprise multiple arrays of sensors in each electrical energy storage pack of the electrical energy storage system. A technical benefit may include more accurate detection of sound waves from multiple locations of the electrical energy storage system, thereby improve prediction of thermal runaway events.

Optionally in some examples, including in at least one preferred example, the sensors may be microphones arranged inside a housing of the electrical energy storage system wirelessly connected to the data collector arranged outside the housing, or the sensors are horn filters connected to waveguides that guide the sound waves to a barometric sensor outside the housing, or accelerometers.

There is further provided a vehicle comprising the system of the third aspect.

The disclosed aspects, examples (including any preferred examples), and/or accompanying claims may be suitably combined with each other as would be apparent to anyone of ordinary skill in the art. Additional features and advantages are disclosed in the following description, claims, and drawings, and in part will be readily apparent therefrom to those skilled in the art or recognized by practicing the disclosure as described herein.

There are also disclosed herein computer systems, control units, code modules, computer-implemented methods, computer readable media, and computer program products associated with the above discussed technical benefits.

**BRIEF DESCRIPTION OF THE DRAWINGS**

**FIG. 1** is an exemplary system diagram of a computer system according to an example.

**FIG. 2** schematically illustrates a training procedure for a supervised learning model according to an example.

**FIG. 3A** is a schematic side view of a system according to one example embodiment.

**FIG. 3B** is a schematic top view of a system according to one example embodiment.

**FIG. 4A** is a schematic side view of a system according to one example embodiment.

**FIG. 4B** is a schematic top view of a system according to one example embodiment.

**FIG. 5** is a flow-chart of method steps according to one example embodiment.

**FIG. 6** is another view of **FIG. 1,** according to an example.

**FIG. 7** is a flow chart of an exemplary method according to an example.

**FIG. 8** is a schematic diagram of an exemplary computer system for implementing examples disclosed herein, according to an example.

## DETAILED DESCRIPTION

The detailed description set forth below provides information and examples of the disclosed technology with sufficient detail to enable those skilled in the art to practice the disclosure.

During a thermal runaway event in electrical energy storage devices such as batteries, temperatures exceeding 1000°C may occur in the cell of the battery. In addition, high amounts of flammable and harmful gases are typically released. The heat developed in one cell during a thermal runaway event can trigger a thermal runaway event in surrounding cells of the battery thereby leading to thermal runaway propagation which may have severe consequences in terms of damage and injury. Although a thermal runaway event can be detected using for example temperature sensors, the detection may be too late, and an escalating thermal runaway may already have been initiated. Therefore, it is desirable to detect or predict a thermal runaway event earlier so that preventive measures can be taken as soon as possible to reduce the risk of an escalating thermal runaway.

To address the above discussed problem, the inventors realized to measure pressure or sound waves generated in the cells of the electric energy storage system as will be laid out in more detail below.

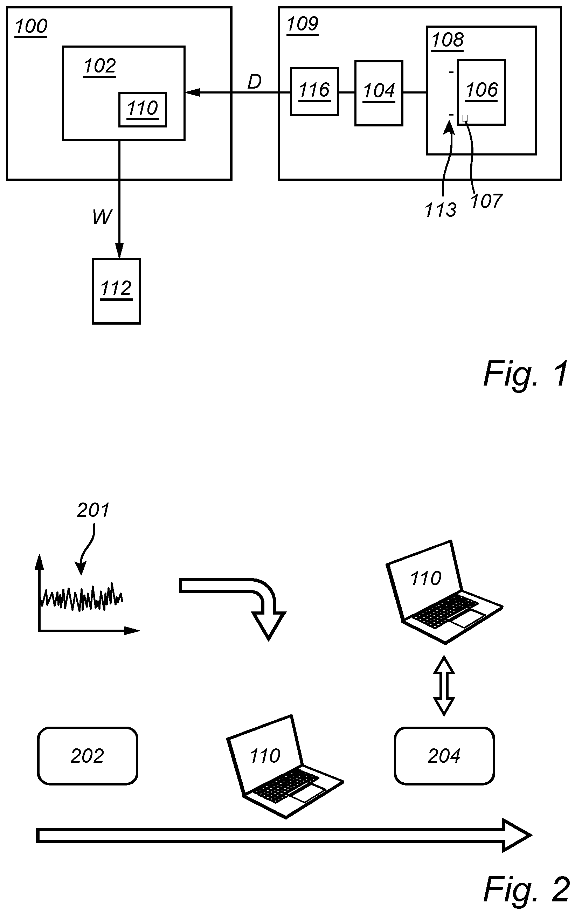

**FIG. 1** is an exemplary system diagram of a computer system 100 comprising processing circuitry 102.

The processing circuitry 102 is configured to receive sensing data D from at least one sensor 104 arranged to detect sound waves emitted from electrical energy storage cells 106 of an electric energy storage system 108. The sensing data D indicates at least one characteristic of the sound waves. The data D are transmitted to the processing circuitry 102 via an optional transmitter 116.

The electric energy storage system 108 may be arranged as a propulsion electrical energy storage system providing propulsion energy to a vehicle 109. The vehicle may be an electrical, hybrid, or plug-in hybrid vehicle comprising an electrical engine, wherein the electrical energy storage system provides energy to the electrical engine. Furthermore, the disclosure can equally well be applied to stationary applications marine applications.

The electrical energy storage system comprises multiple cells 106 arranged in series and in parallel as is known in the art.

Embodiments of the present disclosure is applicable to any type of electrical energy storage system, i.e., battery, that has liquid type of electrolyte, for example, Li-ion, lead-acid, etc.

The processing circuitry 102 is configured to apply an algorithm 110 configured to predict a thermal runaway event by analyzing the sensing data D. The sensing data D may comprise time domain data of the soundwaves from which various properties can be derived including magnitude and frequency but also phase information and variations of these in time, all of which may be characteristics of the sound waves.

The processing circuitry 102 is further configured to provide a message W if the outcome of the analysis is that a thermal runaway is predicted. The electronic message W may be provided to a control unit 112 of for example a vehicle or a stationary application. The message W may provide an instruction for the control unit 112 to activate cooling of the cells 106, or to control a switching circuitry to disconnect modules or cells 106, or other actions to prevent thermal runaway, and/or to transmit a message to an occupant via a user interface 114 to for example leave the vehicle. A user interface 114 of the vehicle may be an audio output device, a display or other visual indicators.

The characteristics of the sound waves may be at least one of frequency spectrum, magnitude, phase, of the sound waves. Generally, any characteristic forming a fingerprint of a sound wave may be used in the algorithm for recognition of an upcoming thermal event.

The sound waves 113 that are detected by the sensors 104 are generated from gas bubbles 107 in the electrical energy storage cells 106. The sound waves are caused by bubble vibration, rising, bursting, coalescence, collision and implosion of bubbles, and resonance of bubbles. As a cell approaches a thermal runaway event, the gas bubbles in the cells 106 change character due to that the material properties inside the cells 106 change. Stated otherwise, acoustic propagation from within the cell 106 is altered due to the changing material properties.

The inventors thus realized that there is a sequence of events in a liquid electrical energy storage cell before it reaches thermal runaway, including electrolyte evaporation and gas production. These events produce gas bubbles 107 which generate pressure/acoustic waves 113 which include different range of frequencies. However, the early phase is mainly governed by low frequency events or infrasound.

One of the sources of sound is the so-called Minnaert resonance which is a phenomenon associated with a gas bubble pulsating at its natural frequency in a liquid. Technically the gas bubble frequency, f, inside liquid is calculated by,

$$f = \frac{1}{2\pi a}\sqrt{\frac{3\gamma P_0}{\rho}}$$

Where $a$ is the radius of the bubble, $\gamma$ is the polytropic efficiency, $P_0$ is the pressure inside gas bubble and $\rho$ is the difference between the density of water and bulk density of the gas bubble. For a single bubble in electrolyte and $\rho = 1200\,\frac{kg}{m^3}$, the equation becomes $fa = 2.6$. Therefore, as an example bubbles in the order of 10 mm emits frequencies around 200 Hz. Larger bubbles can generate smaller frequencies which could be around 52 Hz for a 50 mm bubble.

As sound wave travels, its energy is slowly lost as heat because the molecules of the medium through which it is travelling collide against each other when they transmit the sound wave energy. The rate at which a sound wave is absorbed by a barrier depends on its frequency. If the barrier is wider than the wavelength of the sound wave, the sound wave will be absorbed. As a simple example, a sine wave at 20Hz has a wavelength of 17 meters and will therefore pass through most barriers.

As an example, a bubble with wave frequency of 500 Hz inside salty water has wavelength of 3.12 meter. This wavelength will allow it to travel through existing barriers in an electrical energy storage system. For most electrical energy storage systems 108, the dimensions of the cell 106 and surrounding components, the sensors 104 can detect bubbles with frequency of 5 kHz and diameter of 100 micrometer. Generally speaking, a low frequency wave has the ability to travel long distances with little dissipation which leads to fewer required sensors per electrical energy storage pack.

One source of the sound waves may thus be the bubble Minnaert resonance. Furthermore, another source may be bubbles bursting or collapsing which generates sound waves in the range of 0.5-5 kHz.

The processing circuitry 102 is preferably further configured to predict the thermal runaway event by analyzing sound waves at characteristic frequencies of electrolyte boiling preceding a thermal runaway event. The frequencies may be below 5 kHz, such as in the range of 100 Hz-2 kHz, or 1 kHz to 2 kHz, or below 500 Hz.

Preferably, the algorithm 110 is a machine learning model trained to predict thermal runaway events from detection of acoustic waves generated from gas bubbles in electrical energy storage cells. Such machine learning model may be a supervised learning model 110 trained on acoustic data from test cells to create a fingerprint library of characteristic sounds of thermal runaway events.

In some possible implementations, the computer system 100 is remotely located from the electrical energy storage system 100. The processing circuitry 102 may for example be part of a cloud-based system arranged on a server. Thus, the processing circuitry 102 is configured to receive the sensing data D wirelessly from a transmitter 116 connected to the sensors 104. The transmission technology may be for example Wifi, or any other available telecommunications technology such as mobile networks.

FIG. 2 schematically illustrates a training procedure for a supervised learning model 110. Multiple recordings 201, such as hundreds or thousands or more, or acoustic waves generated by multiple test cells 202 prior to a thermal runaway event are made in a controlled environment such as a laboratory. The recordings are labelled as belonging to thermal runaway events and are fed to the supervised learning model 110 which creates a fingerprint library of the characteristic sounds prior to, i.e., several minutes prior to a thermal runaway event. The supervised model 110 is thus taught to classify new data as belonging to a near future thermal runaway event. The supervised model 110 is subsequently evaluated and tested on a validation set of cells 204.

Supervised learning algorithms are in general advantageously used for applications where labelled training data is available. For the present disclosure, labeled recordings are available from prior recordings, where the data from libraries of recordings is labelled as thermal runaway event or not belonging to thermal runaway events.

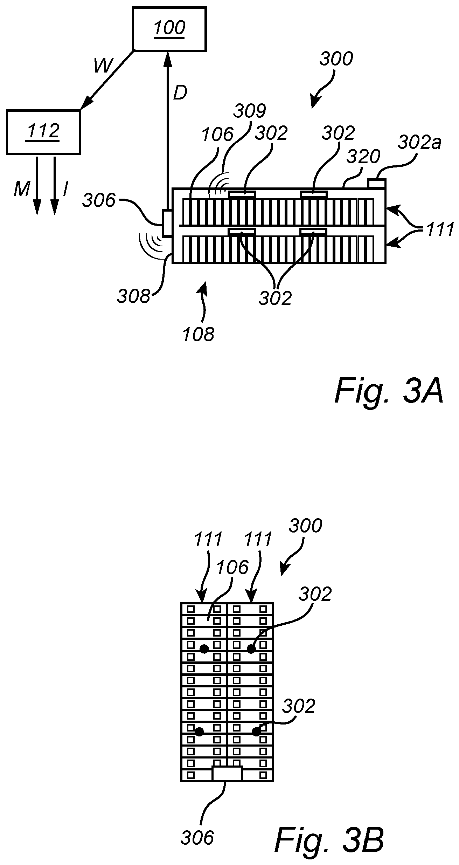

FIG. 3A is a schematic side view and FIG. 3B is a schematic top view of a system 300 for detecting a thermal runaway in an electrical energy storage system 108 of a vehicle 109 or stationary application. The electrical energy storage system 108 comprises multiple electrical energy storage cells 106 distributed over more than one electrical energy storage pack 111.

A set of sensors 302 are arranged to detect sound waves emitted from electrical energy storage cells 106 of the electrical energy storage system 108. As discussed above, the sensing data D indicating at least one characteristic of the sound waves. A greater number of sensors advantageously provides higher signal-to-noise ratio.

The sensors 302 are here represented by an array of microphones 302 or accelerometers connected to the data collector 306, or transmitter, according to an example embodiment.

The microphones 302 detect pressure/sound waves outside the cells 106 but that are generated in the cells 106. The microphones 302 transform the detected waves to electric impulses/signals and transmit the electric signals to the transmitter 306 via either hard wires or via wireless communication such as Bluetooth, Wi-Fi, etc. The transmitter 306 sends data D to the computer system 100, where the processing circuitry 102 is configured to apply the algorithm 110 to predict a thermal runaway event by analyzing the sensing data.

If the outcome of the analysis performed by the processing circuitry 102 is that a thermal runaway is predicted, a vehicle processing circuitry 112 is configured to provide a message. The processing circuitry may equally well be a or stationary application processing circuitry. The processing circuitry 112 receives a message W from the processing circuitry 102 with an instruction that a thermal runaway is predicted so that, in response, the processing circuitry 112 can provide the warning message M or an instruction I to perform preventive actions by for example cooling systems or switching circuitry of the electrical energy storage system 108. Using the herein proposed analysis, the warning message M or instruction I may be provided as early as 15 minutes before a thermal runaway event.

Preferably, multiple arrays of sensors 302 are arranged in each electrical energy storage pack of the electrical energy storage system 108. The sensors 302 may be arranged inside a housing 308 of the electrical energy storage system 108, on the cells 106. That is the sensors 302 may be integrated within the electrical energy storage pack 111.

In this system 300, the sensors are microphones 302 arranged inside a housing 308 of the electrical energy storage system 108 and preferably wirelessly 309 connected to the data collector 306 arranged outside the housing 308. That is the microphones 302 may be integrated within the electrical energy storage pack 111. However, as indicated, the microphones 302a may equally well be placed on the external outer surface 320 of the housing 308, thus not integrated inside the housing 308.

In some embodiments the sensors may be accelerometers. Accelerometers can measure the structural vibrations of the cells caused by the gas bubbles inside the electrical energy storage pack 111. The analysis follows that used when the sensors are microphones.

The choice of accelerometer or microphone may depend on for example the available space inside or on the surface of the electrical energy storage packs.

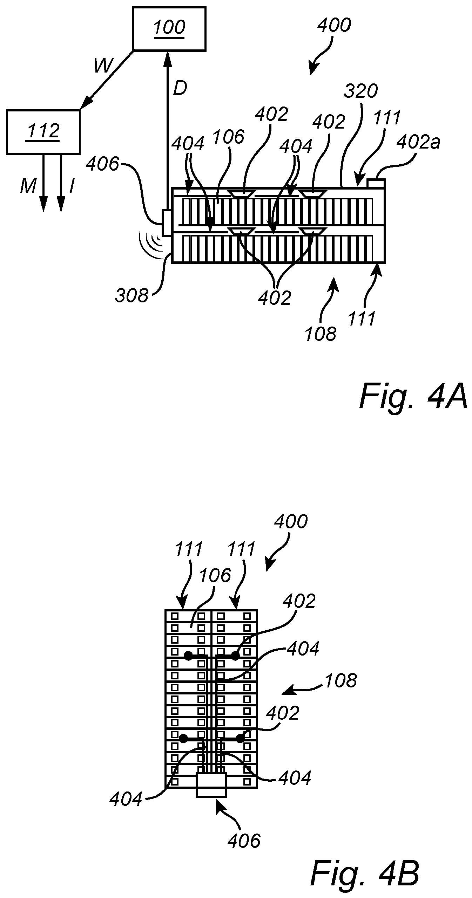

FIG. 4A is a schematic side view and FIG. 4B is a schematic top view of a system 400 for detecting a thermal runaway in an electrical energy storage system 108..

In this embodiment, the sensors may be receivers 402 including horn shaped filters connected to waveguides 404. Further, the receivers 402 may include an amplifier which amplifies the received sound before transmission to a data collector 406, here being a barometric sensor 406 at the other end of the waveguides 404. The barometric sensor 406 transforms detected and amplified sound waves to electrical impulses. Next, data from the barometric sensor 406 are transmitted to the processing circuitry 102 of the computer system 100 configured to apply the algorithm 110 configured to predict a thermal runaway event by analyzing the sensing data.

The waveguides 404 being in the form of pipes advantageously serves to filter out high frequency sound waves.

The receivers 402 may be arranged inside the housing 308 or receivers 402a may be arranged on the outside surface 320 of the housing 308.

Every electrical energy storage pack 111 may comprise a dedicated barometric sensor or a global barometric sensor may be used for multiple electrical energy storage packs 111. The barometric sensor may be an infrasound sensor, that is, a pressure wave sensor that is adapted to detect low frequency sound, such as below 5 kHz, below 1 kHz, below 500 Hz, or even below 100 Hz, or below 50 Hz.

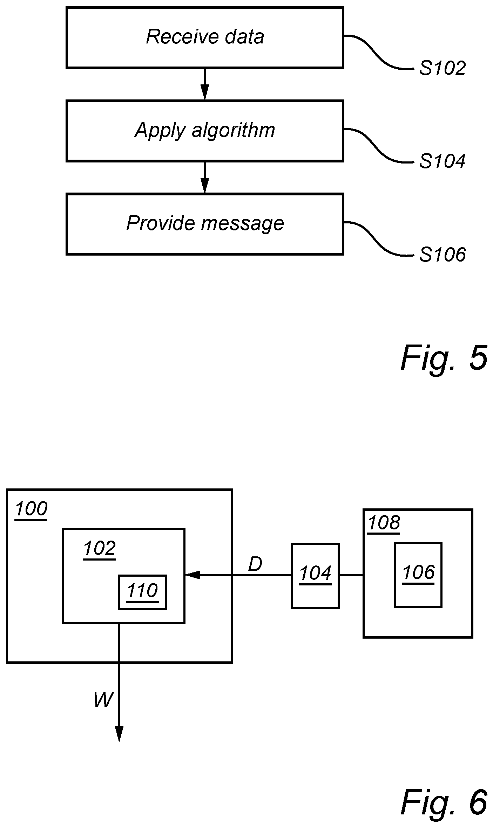

FIG. 5 is a flow-chart of method steps according to embodiments of the present disclosure.

In step S102, receiving, by processing circuitry 102 of a computer system 100, sensing data D from at least one sensor 104 arranged to detect sound waves emitted from electrical energy storage cells 106 of an electrical energy storage system, the sensing data indicating at least one characteristic of the sound waves. In other words, the sound waves generated in the electrical energy storage cells 106 as result of gas bubble dynamics in the fluid of the cells 106 are received by the sensors 104, and data thereof is transmitted to the processing circuitry 102.

In step S104 applying, by the processing circuitry 102, an algorithm 110 configured to predict a thermal runaway event by analyzing the sensing data. Preferably, the algorithm is a machine learning model trained to predict thermal runaway events from detection of acoustic waves generated from gas bubbles in electrical energy storage cells. The machine learning model may be supervised learning model trained on acoustic data from test cells to create a fingerprint library of characteristic sounds of thermal runaway events.

In step S106, providing, by the processing circuitry 102, a warning message if the outcome of the analysis is that a thermal runaway is predicted.

In order to filter out sound dynamics that are not relevant for prediction of thermal runaway events from gas bubble dynamics, the analysis may be performed for sound waves at characteristic frequencies of electrolyte boiling preceding a thermal runaway event. For example, such frequencies may be below 5 kHz, such as in the range of 1-2 kHz, or 20 Hz to 500 Hz, to predict the thermal runaway event.

FIG. 6 is another view of FIG. 1, according to an example. FIG. 6 illustrates a computer system 100 comprising processing circuitry 102 configured to: receive sensing data D from at least one sensor 104 arranged to detect sound waves emitted from electrical energy storage cells 106 of an electrical energy storage system 108, the sensing data D indicating at least one characteristic of the sound waves.

The processing circuitry 102 is configured to apply an algorithm 110 configured to predict a thermal runaway event by analyzing the sensing data D and provide a warning message W if the outcome of the analysis is that a thermal runaway is predicted.

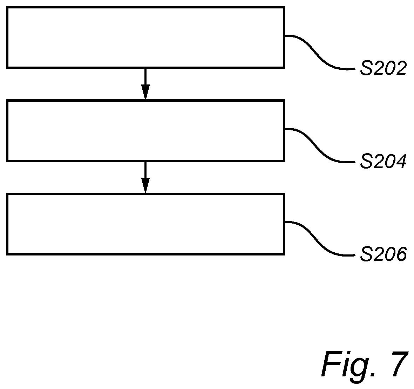

FIG. 7 is a flow chart of a method according to an example.

In step S202 receiving, by processing circuitry of a computer system, sensing data from at least one sensor arranged to detect sound waves emitted from electrical energy storage cells of an electrical energy storage system, the sensing data indicating at least one characteristic of the sound waves.

In step S204 applying, by the processing circuitry, an algorithm configured to predict a thermal runaway event by analyzing the sensing data.

In step S206 providing, by the processing circuitry, a warning message if the outcome of the analysis is that a thermal runaway is predicted.

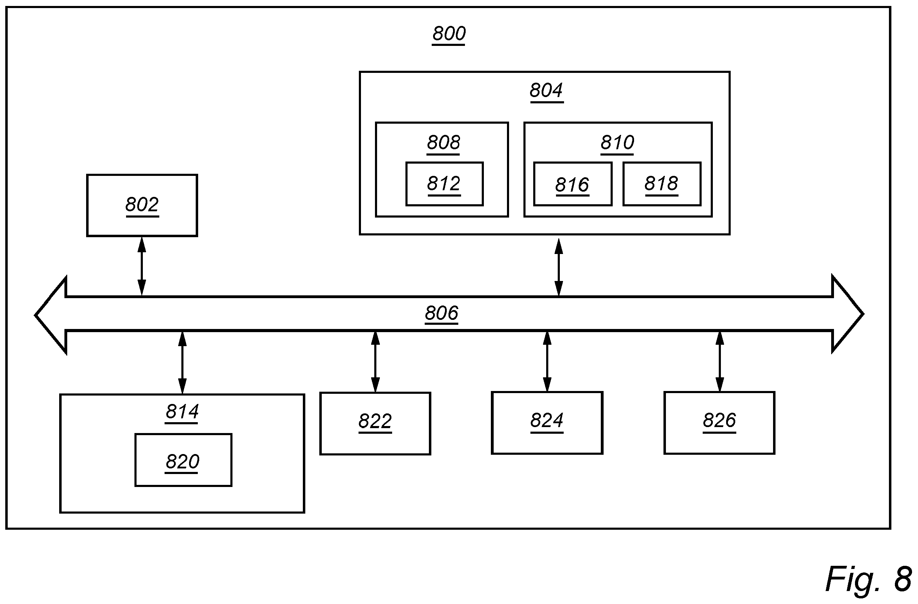

FIG. 8 is a schematic diagram of a computer system **800** for implementing examples disclosed herein. The computer system **800** is adapted to execute instructions from a computer-readable medium to perform these and/or any of the functions or processing described herein. The computer system **800** may be connected (e.g., networked) to other machines in a LAN, an intranet, an extranet, or the Internet. While only a single device is illustrated, the computer system **800** may include any collection of devices that individually or jointly execute a set (or multiple sets) of instructions to perform any one or more of the methodologies discussed herein. Accordingly, any reference in the disclosure and/or claims to a computer system, computing system, computer device, computing device, control system, control unit, electronic control unit (ECU), processor device, processing circuitry, etc., includes reference to one or more such devices to individually or jointly execute a set (or multiple sets) of instructions to perform any one or more of the methodologies discussed herein. For example, control system may include a single control unit or a plurality of control units connected or otherwise communicatively coupled to each other, such that any performed function may be distributed between the control units as desired. Further, such devices may communicate with each other or other devices by various system architectures, such as directly or via a Controller Area Network (CAN) bus, etc.

The computer system **800** may comprise at least one computing device or electronic device capable of including firmware, hardware, and/or executing software instructions to implement the functionality described herein. The computer system **800** may include processing circuitry **802** (e.g., processing circuitry including one or more processor devices or control units), a memory **804,** and a system bus **806.** The computer system **800** may include at least one computing device having the processing circuitry **802**. The system bus **806** provides an interface for system components including, but not limited to, the memory **804** and the processing circuitry **802**. The processing circuitry **802** may include any number of hardware components for conducting data or signal processing or for executing computer code stored in memory **804**. The processing circuitry **802** may, for example, include a general-purpose processor, an application specific processor, a Digital Signal Processor (DSP), an Application Specific Integrated Circuit (ASIC), a Field Programmable Gate Array (FPGA), a circuit containing processing components, a group of distributed processing components, a group of distributed computers configured for processing, or other programmable logic device, discrete gate or transistor logic, discrete hardware components, or any combination thereof designed to perform the functions described herein. The processing circuitry **802** may further include computer executable code that controls operation of the programmable device.

The system bus **806** may be any of several types of bus structures that may further interconnect to a memory bus (with or without a memory controller), a peripheral bus, and/or a local bus using any of a variety of bus architectures. The memory **804** may be one or more devices for storing data and/or computer code for completing or facilitating methods described herein. The memory **804** may include database components, object code components, script components, or other types of information structure for supporting the various activities herein. Any distributed or local memory device may be utilized with the systems and methods of this description. The memory **804** may be communicably connected to the processing circuitry **802** (e.g., via a circuit or any other wired, wireless, or network connection) and may include computer code for executing one or more processes described herein. The memory **804** may include non-volatile memory **808** (e.g., read-only memory (ROM), erasable programmable read-only memory (EPROM), electrically erasable programmable read-only memory (EEPROM), etc.), and volatile memory **810** (e.g., random-access memory (RAM)), or any other medium which can be used to carry or store desired program code in the form of machine-executable instructions or data structures and which can be accessed by a computer or other machine with processing circuitry **802**. A basic input/output system (BIOS) **812** may be stored in the non-volatile memory **808** and can include the basic routines that help to transfer information between elements within the computer system **800**.

The computer system **800** may further include or be coupled to a non-transitory computer-readable storage medium such as the storage device **814,** which may comprise, for example, an internal or external hard disk drive (HDD) (e.g., enhanced integrated drive electronics (EIDE) or serial advanced technology attachment (SATA)), HDD (e.g., EIDE or SATA) for storage, flash memory, or the like. The storage device **814** and other drives associated with computer-readable media and computer-usable media may provide non-volatile storage of data, data structures, computer-executable instructions, and the like.

Computer-code which is hard or soft coded may be provided in the form of one or more modules. The module(s) can be implemented as software and/or hard-coded in circuitry to implement the functionality described herein in whole or in part. The modules may be stored in the storage device **814** and/or in the volatile memory **810,** which may include an operating system **816** and/or one or more program modules **818.** All or a portion of the examples disclosed herein may be implemented as a computer program **820** stored on a transitory or non-transitory computer-usable or computer-readable storage medium (e.g., single medium or multiple media), such as the storage device **814,** which includes complex programming instructions (e.g., complex computer-readable program code) to cause the processing circuitry **802** to carry out actions described herein. Thus, the computer-readable program code of the computer program **820** can comprise software instructions for implementing the functionality of the examples described herein when executed by the processing circuitry **802.** In some examples, the storage device **814** may be a computer program product (e.g., readable storage medium) storing the computer program **820** thereon, where at least a portion of a computer program **820** may be loadable (e.g., into a processor) for implementing the functionality of the examples described herein when executed by the processing circuitry **802.** The processing circuitry **802** may serve as a controller or control system for the computer system **800** that is to implement the functionality described herein.

The computer system **800** may include an input device interface **822** configured to receive input and selections to be communicated to the computer system **800** when executing instructions, such as from a keyboard, mouse, touch-sensitive surface, etc. Such input devices may be connected to the processing circuitry **802** through the input device interface **822** coupled to the system bus **806** but can be connected through other interfaces, such as a parallel port, an Institute of Electrical and Electronic Engineers (IEEE) 1394 serial port, a Universal Serial Bus (USB) port, an IR interface, and the like. The computer system **800** may include an output device interface **824** configured to forward output, such as to a display, a video display unit (e.g., a liquid crystal display (LCD) or a cathode ray tube (CRT)). The computer system **800** may include a communications interface **826** suitable for communicating with a network as appropriate or desired.

The operational actions described in any of the exemplary aspects herein are described to provide examples and discussion. The actions may be performed by hardware components, may be embodied in machine-executable instructions to cause a processor to perform the actions, or may be performed by a combination of hardware and software. Although a specific order of method actions may be shown or described, the order of the actions may differ. In addition, two or more actions may be performed concurrently or with partial concurrence.

Example 1: A computer system comprising processing circuitry configured to: receive sensing data from at least one sensor arranged to detect sound waves emitted from electrical energy storage cells of an electrical energy storage system, the sensing data indicating at least one characteristic of the sound waves, apply an algorithm configured to predict a thermal runaway event by analyzing the sensing data, provide a message if the outcome of the analysis is that a thermal runaway is predicted.

Example 2: The computer system of example 1, wherein the algorithm is a machine learning model trained to predict thermal runaway events from detection of acoustic waves generated from gas bubbles in electrical energy storage cells.

Example 3: The computer system of example 2, the machine learning model is a supervised learning model trained on acoustic data from test cells to create a fingerprint library of characteristic sounds of thermal runaway events.

Example 4: The computer system of any of examples 1-3, wherein the processing circuitry is further configured to: predict the thermal runaway event by analyze sound waves at characteristic frequencies of electrolyte boiling preceding a thermal runaway event.

Example 5: The computer system of any of examples 1-4, wherein the processing circuitry is configured to receive the sensing data wirelessly from a transmitter connected to the sensors.

Example 6: The computer system of any of examples 1-5, wherein sensing data is received from multiple sensors.

Example 7: The computer system of any of examples 1-6, wherein the sensors in the electrical energy storage system are at least one of microphones, horn filters connected to waveguides, or accelerometers.

Example 8: A computer-implemented method, comprising:

receiving, by processing circuitry of a computer system, sensing data from at least one sensor arranged to detect sound waves emitted from electrical energy storage cells of an electrical energy storage system, the sensing data indicating at least one characteristic of the sound waves, applying, by the processing circuitry, an algorithm configured to predict a thermal runaway event by analyzing the sensing data, providing, by the processing circuitry, a message if the outcome of the analysis is that a thermal runaway is predicted.

Example 9: The computer-implemented method of example 8, wherein the algorithm is a machine learning model trained to predict thermal runaway events from detection of acoustic waves generated from gas bubbles in electrical energy storage cells.

Example 10: The computer-implemented method of example 9, the machine learning model is a supervised learning model trained on acoustic data from test cells to create a fingerprint library of characteristic sounds of thermal runaway events.

Example 11: The computer-implemented method of any of examples 8-10, comprising: analyzing, by the processing circuitry, sound waves at characteristic frequencies of electrolyte boiling preceding a thermal runaway event, to predict the thermal runaway event.

Example 12: The computer-implemented method of any of examples 8-11, comprising:
receiving, by the processing circuitry, the sensing data wirelessly from a transmitter connected to the sensors.

Example 13: The computer-implemented method of any of examples 8-12, wherein sensing data is received from multiple sensors connected to a barometric sensor configured to transmit the sensing data to the processing circuitry.

Example 14: The computer-implemented method of any of examples 8-13, wherein the sensors in the electrical energy storage system are at least one of microphones, horn filters connected to waveguides, or accelerometers.

Example 15: A computer program product comprising program code for performing, when executed by the processing circuitry, the method of any of examples 8-14.

Example 16: A non-transitory computer-readable storage medium comprising instructions, which when executed by the processing circuitry, cause the processing circuitry to perform the method of any of examples 8-14.

Example 17: A system for detecting a thermal runaway in an electrical energy storage system of a vehicle, the system comprising: a set of sensors arranged to detect sound waves emitted from electrical energy storage cells of the electrical energy storage system, the sensing data indicating at least one characteristic of the sound waves, data collector configured to receive sensing signals from the sensors and transmit sensing data to processing circuitry configured to apply an algorithm configured to predict a thermal runaway event by analyzing the sensing data, and a vehicle processing circuitry configured to provide a message if the outcome of the analysis is that a thermal runaway is predicted.

Example 18: The system of example 17, comprising multiple arrays of sensors in each electrical energy storage pack of the electrical energy storage system.

Example 19: The system of any of examples 18-17, wherein the sensors are microphones arranged inside a housing of the electrical energy storage system wirelessly connected to the data collector arranged outside the housing, or the sensors are horn filters connected to waveguides that guide the sound waves to a barometric sensor outside the housing, or accelerometers.

Example 20: A vehicle comprising the system of any of examples 17-19.

The terminology used herein is for the purpose of describing particular aspects only and is not intended to be limiting of the disclosure. As used herein, the singular forms "a," "an," and "the" are intended to include the plural forms as well, unless the context clearly indicates otherwise. As used herein, the term "and/or" includes any and all combinations of one or more of the associated listed items. It will be further understood that the terms "comprises," "comprising," "includes," and/or "including" when used herein specify the presence of stated features, integers, actions, steps, operations, elements, and/or components, but do not preclude the presence or addition of one or more other features, integers, actions, steps, operations, elements, components, and/or groups thereof.

It will be understood that, although the terms first, second, etc., may be used herein to describe various elements, these elements should not be limited by these terms. These terms are only used to distinguish one element from another. For example, a first element could be termed a second element, and, similarly, a second element could be termed a first element without departing from the scope of the present disclosure.

Relative terms such as "below" or "above" or "upper" or "lower" or "horizontal" or "vertical" may be used herein to describe a relationship of one element to another element as illustrated in the Figures. It will be understood that these terms and those discussed above are intended to encompass different orientations of the device in addition to the orientation depicted in the Figures. It will be understood that when an element is referred to as being "connected" or "coupled" to another element, it can be directly connected or coupled to the other element, or intervening elements may be present. In contrast, when an element is referred to as being "directly connected" or "directly coupled" to another element, there are no intervening elements present.

Unless otherwise defined, all terms (including technical and scientific terms) used herein have the same meaning as commonly understood by one of ordinary skill in the art to which this disclosure belongs. It will be further understood that terms used herein should be interpreted as having a meaning consistent with their meaning in the context of this specification and the relevant art and will not be interpreted in an idealized or overly formal sense unless expressly so defined herein.

It is to be understood that the present disclosure is not limited to the aspects described above and illustrated in the drawings; rather, the skilled person will recognize that many changes and modifications may be made within the scope of the present disclosure and appended claims. In the drawings and specification, there have been disclosed aspects for purposes of illustration only and not for purposes of limitation, the scope of the disclosure being set forth in the following claims.

**Claims**

1. A computer system (100) comprising processing circuitry (102) configured to:

   receive sensing data (D) from at least one sensor (104) arranged to detect sound waves emitted from electrical energy storage cells (106) of an electrical energy storage system (108), the sensing data indicating at least one characteristic of the sound waves,
   apply an algorithm (110) configured to predict a thermal runaway event by analysing the sensing data for sound waves at characteristic frequencies of electrolyte boiling preceding a thermal runaway event,
   provide a message (W) if the outcome of the analysis is that a thermal runaway is predicted.

2. The computer system of claim 1, wherein the algorithm is a machine learning model trained to predict thermal runaway events from detection of acoustic waves (113) generated from gas bubbles (107) in electrical energy storage cells.

3. The computer system of claim 2, the machine learning model is a supervised learning model trained on acoustic data from test cells to create a fingerprint library of characteristic sounds of thermal runaway events.

4. The computer system of any of claims 1-3, wherein the processing circuitry is configured to receive the sensing data wirelessly from a transmitter (116) connected to the sensors.

5. The computer system of any of claims 1-4, wherein sensing data is received from multiple sensors (302, 402).

6. The computer system of any of claims 1-5, wherein the sensors in the electrical energy storage system are at least one of microphones, horn filters connected to waveguides, or accelerometers.

7. A computer-implemented method, comprising:

   receiving (S102, S202), by processing circuitry of a computer system, sensing data from at least one sensor arranged to detect sound waves emitted from electrical energy storage cells of an electrical energy storage system, the sensing data indicating at least one characteristic of the sound waves,
   applying (S104, S204), by the processing circuitry, an algorithm configured to predict a thermal runaway event by analysing the sensing data for sound waves at characteristic frequencies of electrolyte boiling preceding a thermal runaway event,
providing (S106, S206), by the processing circuitry, a message if the outcome of the analysis is that a thermal runaway is predicted.

8. The computer-implemented method of claim 7, wherein the algorithm is a machine learning model trained to predict thermal runaway events from detection of acoustic waves generated from gas bubbles in electrical energy storage cells.

9. The computer-implemented method of claim 8, the machine learning model is a supervised learning model trained on acoustic data from test cells to create a fingerprint library of characteristic sounds of thermal runaway events.

10. The computer-implemented method any of claims 7-9, comprising:
    receiving, by the processing circuitry, the sensing data wirelessly from a transmitter connected to the sensors.

11. A computer program product comprising program code for performing, when executed by the processing circuitry, the method of any of claims 7-10.

12. A non-transitory computer-readable storage medium comprising instructions, which when executed by the processing circuitry, cause the processing circuitry to perform the method of any of claims 7-10.

13. A system (300, 400) for detecting a thermal runaway in an electrical energy storage system, the system comprising:

    a set of sensors (104, 302, 402) arranged to detect sound waves emitted from electrical energy storage cells (106) of the electrical energy storage system, the sensing data indicating at least one characteristic of the sound waves,
    data collector (306) configured to receive sensing signals from the sensors and transmit sensing data to processing circuitry configured to apply an algorithm configured to predict a thermal runaway event by analyzing the sensing data for sound waves at characteristic frequencies of electrolyte boiling preceding a thermal runaway event, and
    a processing circuitry (112) configured to provide a message if the outcome of the analysis is that a thermal runaway is predicted.

**Patentansprüche**

1.  Computersystem (100) umfassend eine Verarbeitungsschaltung (102), die konfiguriert ist zum:

    Empfangen von Sensordaten (D) von mindestens einem Sensor (104), der angeordnet ist, um Schallwellen zu erfassen, die von elektrischen Energiespeicherzellen (106) eines elektrischen Energiespeichersystems (108) emittiert werden, wobei die Sensordaten mindestens eine Eigenschaft der Schallwellen anzeigen,
    Anwenden eines Algorithmus (110), der konfiguriert ist, um ein thermisches Durchgehenereignis vorherzusagen, indem er die Sensordaten für Schallwellen bei charakteristischen Frequenzen des Elektrolytsiedens analysiert, das einem thermischen Durchgehenereignis vorausgeht,
    Bereitstellen einer Meldung (W), wenn das Ergebnis der Analyse lautet, dass ein thermisches Durchgehen vorhergesagt wird.

2.  Computersystem nach Anspruch 1, wobei es sich bei dem Algorithmus um einen maschinellen Lernmodus handelt, der darauf trainiert ist, thermische Durchgehenereignisse aus der Detektion akustischer Wellen (113) vorherzusagen, die aus Gasblasen (107) in elektrischen Energiespeicherzellen erzeugt werden.

3.  Computersystem nach Anspruch 2, wobei das maschinelle Lernmodell ein überwachtes Lernmodell ist, das auf akustischen Daten von Testzellen trainiert wurde, um eine Fingerabdruckbibliothek charakteristischer Geräusche von thermischen Durchgehenereignissen zu erstellen.

4.  Computersystem nach einem der Ansprüche 1-3, wobei die Verarbeitungsschaltung konfiguriert ist, um die Sensordaten drahtlos von einem mit den Sensoren verbundenen Sender (116) zu empfangen.

5.  Computersystem nach einem der Ansprüche 1-4, wobei die Sensordaten von mehreren Sensoren (302, 402) empfangen werden.

6.  Computersystem nach einem der Ansprüche 1-5, wobei die Sensoren in dem elektrischen Energiespeichersystem mindestens eines der folgenden Elemente sind: Mikrofone, Hornfilter, die mit Wellenleitern verbunden sind, oder Beschleunigungsmesser.

7.  Computer-implementiertes Verfahren, umfassend:

    Empfangen (S102, S202) von Sensordaten von mindestens einem Sensor durch die Verarbeitungsschaltung eines Computersystems, der so angeordnet ist, dass er von elektrischen Energiespeicherzellen eines elektrischen Energiespeichersystems emittierte Schallwellen erfasst, wobei die Sensordaten mindestens eine Eigenschaft der Schallwellen angeben,
    Anwenden (S104, S204) durch die Verarbeitungsschaltung eines Algorithmus, der konfiguriert ist, um ein thermisches Durchgehenereignis vorherzusagen, indem er die Sensordaten für Schallwellen bei charakteristischen Frequenzen des Elektrolytsiedens analysiert, das einem thermischen Durchgehenereignis vorausgeht,
    Bereitstellen (S106, S206) einer Meldung durch die Verarbeitungsschaltung, wenn das Ergebnis der Analyse lautet, dass ein thermisches Durchgehen vorhergesagt wird.

8.  Computer-implementiertes Verfahren nach Anspruch 7, wobei es sich bei dem Algorithmus um ein maschinelles Lernmodell handelt, das darauf trainiert ist, thermische Durchgehenereignisse aus der Detektion von akustischen Wellen vorherzusagen, die aus Gasblasen in elektrischen Energiespeicherzellen erzeugt werden.

9.  Computer-implementiertes Verfahren nach Anspruch 8, wobei das maschinelle Lernmodell ein überwachtes Lernmodell ist, das auf akustischen Daten von Testzellen trainiert wurde, um eine Fingerabdruckbibliothek charakteristischer Geräusche von thermischen Durchgehenereignissen zu erstellen.

10. Computer-implementierte Verfahren nach einem der Ansprüche 7-9, umfassend:
    drahtloses Empfangen durch die Verarbeitungsschaltung der Sensordaten von einem mit den Sensoren verbundenen Sender.

11. Computerprogrammprodukt mit einem Programmcode zum Durchführen des Verfahrens nach einem der Ansprüche 7-10, wenn es von einer Verarbeitungsschaltung ausgeführt wird.

12. Nicht-transitorisches computerlesbares Speichermedium, das Anweisungen umfasst, die, wenn sie von einer Verarbeitungsschaltung ausgeführt werden, die Verarbeitungsschaltung veranlassen, das Verfahren nach einem der Ansprüche 7-10 durchzuführen.

13. System (300, 400) zur Detektion eines thermischen Durchgehens in einem elektrischen Energiespeichersystem, das System umfassend:

eine Reihe von Sensoren (104, 302, 402), die angeordnet sind, um von elektrischen Energiespeicherzellen (106) des elektrischen Energiespeichersystems abgegebene Schallwellen zu erfassen, wobei die Sensordaten mindestens eine Eigenschaft der Schallwellen anzeigen, Datensammler (306), der konfiguriert ist, um Sensorsignale von den Sensoren zu empfangen und Sensordaten an eine Verarbeitungsschaltung zu übertragen, die konfiguriert ist, um einen Algorithmus anzuwenden, der konfiguriert ist, um ein Durchgehenereignis vorherzusagen, indem er die Sensordaten für Schallwellen bei charakteristischen Frequenzen des Elektrolytsiedens analysiert, das einem thermischen Durchgehenereignis vorausgeht, und eine Verarbeitungsschaltung (112), die konfiguriert ist, um eine Meldung bereitzustellen, wenn das Ergebnis der Analyse lautet, dass ein thermisches Durchgehen vorhersagt wird.

## Revendications

1.  Système informatique (100) comprenant des circuits de traitement (102) configurés pour :

    recevoir des données de détection (D) d'au moins un capteur (104) conçu pour détecter des ondes sonores émises par des cellules de stockage d'énergie électrique (106) d'un système de stockage d'énergie électrique (108), les données de détection indiquant au moins une caractéristique des ondes sonores,
    appliquer un algorithme (110) configuré pour prédire un événement d'emballement thermique en analysant les données de détection pour les ondes sonores à des fréquences caractéristiques d'ébullition d'électrolyte précédant un événement d'emballement thermique,
    émettre un message (W) si le résultat de l'analyse est qu'un emballement thermique est prédit.

2.  Système informatique selon la revendication 1, dans lequel l'algorithme est un modèle d'apprentissage automatique formé pour prédire des événements d'emballement thermique à partir de la détection d'ondes acoustiques (113) générées à partir de bulles de gaz (107) dans des cellules de stockage d'énergie électrique.

3.  Système informatique selon la revendication 2, dans lequel le modèle d'apprentissage automatique est un modèle d'apprentissage supervisé entraîné sur des données acoustiques provenant de cellules de test pour créer une bibliothèque d'empreintes digitales de sons caractéristiques d'événements d'emballement thermique.

4.  Système informatique selon l'une quelconque des revendications 1 à 3, dans lequel le circuit de traitement est configuré pour recevoir les données de détection sans fil à partir d'un émetteur (116) connecté aux capteurs.

5.  Système informatique selon l'une quelconque des revendications 1 à 4, dans lequel des données de détection sont reçues de capteurs multiples (302, 402).

6.  Système informatique selon l'une quelconque des revendications 1 à 5, dans lequel les capteurs dans le système de stockage d'énergie électrique sont au moins l'un des microphones, filtres à cornet connectés à des guides d'ondes, ou accéléromètres.

7.  Procédé informatisé, comprenant :

    la réception (S102, S202), par des circuits de traitement d'un système informatique, de données de détection provenant d'au moins un capteur conçu pour détecter des ondes sonores émises par des cellules de stockage d'énergie électrique d'un système de stockage d'énergie électrique, les données de détection indiquant au moins une caractéristique des ondes sonores,
    l'application (S104, S204), par le circuit de traitement, d'un algorithme configuré pour prédire un événement d'emballement thermique en analysant les données de détection pour les ondes sonores à des fréquences caractéristiques d'ébullition d'électrolyte précédant un événement d'emballement thermique,
    l'émission (S106, S206), par le circuit de traitement, d'un message si le résultat de l'analyse est qu'un emballement thermique est prédit.

8.  Procédé informatisé selon la revendication 7, dans lequel l'algorithme est un modèle d'apprentissage automatique entraîné pour prédire des événements d'emballement thermique à partir de la détection d'ondes acoustiques générées à partir de bulles de gaz dans des cellules de stockage d'énergie électrique.

9.  Procédé informatisé selon la revendication 8, dans lequel le modèle d'apprentissage automatique est un modèle d'apprentissage supervisé formé sur des données acoustiques provenant de cellules de test pour créer une bibliothèque d'empreintes digitales de sons caractéristiques d'événements d'emballement thermique.

10. Procédé informatisé selon l'une quelconque des revendications 7 à 9, comprenant :
la réception, par le circuit de traitement, des données de détection sans fil provenant d'un émetteur connecté aux capteurs.

**11.** Produit de programme informatique comprenant un code de programme pour exécuter, lorsqu'il est exécuté par le circuit de traitement, le procédé selon l'une quelconque des revendications 7 à 10.

**12.** Support de stockage lisible par ordinateur non transitoire comprenant des instructions qui, lorsqu'elles sont exécutées par les circuits de traitement, amènent les circuits de traitement à exécuter le procédé selon l'une quelconque des revendications 7 à 10.

**13.** Système (300, 400) permettant de détecter un emballement thermique dans un système de stockage d'énergie électrique, le système comprenant :

un ensemble de capteurs (104, 302, 402) conçus pour détecter les ondes sonores émises par les cellules de stockage d'énergie électrique (106) du système de stockage d'énergie électrique, les données de détection indiquant au moins une caractéristique des ondes sonores, un collecteur de données (306) configuré pour recevoir des signaux de détection provenant des capteurs et transmettre des données de détection à des circuits de traitement configurés pour appliquer un algorithme configuré pour prédire un événement d'emballement thermique en analysant les données de détection pour des ondes sonores à des fréquences caractéristiques d'ébullition d'électrolyte précédant un événement d'emballement thermique, et
un circuit de traitement (112) configuré pour fournir un message si le résultat de l'analyse est qu'un emballement thermique est prédit.

Fig. 1

Fig. 2

Fig. 3A

Fig. 3B

Fig. 4A

Fig. 4B

Fig. 5

Fig. 6

S202

S204

S206

*Fig. 7*

*Fig. 8*

EP 4 517 915 B1

**EP 4 517 915 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 3772428 A
- CN 218824631
- US 2022123559 A